# EUROPÄISCHE PATENTSCHRIFT

(11) **EP 3 114 740 B1**
(45) Veröffentlichungstag und Bekanntmachung des Hinweises auf die Patenterteilung: **10.06.2020**
(21) Anmeldenummer: 15733334.5
(22) Anmeldetag: 04.03.2015
(51) Int. Cl.: H02G 3/04

(54) **MULTIFUNKTIONALE VORRICHTUNG**
MULTIFUNCTIONAL APPARATUS
DISPOSITIF MULTIFONCTION

(30) Priorität: 04.03.2014 DE 102014102865; 08.07.2014 DE 202014103136 U; 08.09.2014 DE 102014112910; 24.12.2014 DE 102014119631
(43) Veröffentlichungstag der Anmeldung: 11.01.2017
(73) Patentinhaber: GfP Gesellschaft für Produktentwicklung und Produktivitätsplanung mbH, 74613 Öhringen (DE)
(72) Erfinder: NOTHEIS, Alexander, Karlsruhe Baden 76131 (DE); ROSS, Zoltan, Stuttgart 70599 (DE); KEUSCH, Siegfried, Plochingen 73207 (DE)
(74) Vertreter: Kotitschke, Ralf Thomas
(86) Internationale Anmeldenummer: PCT/DE2015/100086
(87) Internationale Veröffentlichungsnummer: WO 2015/131882

(56) Entgegenhaltungen:
- WO-A1-2008/112675
- DE-B4- 10 164 886
- DE-U1-202004 008 548
- DE-U1-202010 016 699

## Beschreibung

### Technisches Gebiet

Die vorliegende Erfindung betrifft eine multifunktionale Vorrichtung, aufweisend eine zwischen einer, insbesondere horizontalen und/oder unterhalb der Decke eines Raums vorgesehenen, Parkposition und einer nicht-horizontalen Arbeitsposition bewegbare Säule.

### Stand der Technik

Eine derartige Vorrichtung ist zum Beispiel in der Druckschrift EP 1 630 919 A1 offenbart. Allerdings ist die räumliche Erreichbarkeit einer derartigen Vorrichtung durch ihre Schwenkbarkeit um lediglich die horizontale Achse limitiert, was zum Beispiel dann von Nachteil ist, wenn die Tische in einer Lehranstalt inselförmig oder gruppenförmig oder kreisförmig angeordnet sind. Eine weitere derartige Einrichtung ist aus der DE 101 64 886 B4 bekannt.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Vorrichtung der eingangs genannten Art so weiterzubilden, dass eine verbesserte räumliche Erreichbarkeit gewährleistet ist.

Diese Aufgabe wird durch eine multifunktionale Vorrichtung mit den im Anspruch 1 angegebenen Merkmalen gelöst. Vorteilhafte Ausgestaltungen und zweckmäßige Weiterbildungen der vorliegenden Erfindung sind in den Unteransprüchen gekennzeichnet.

Die vorliegende Erfindung beruht auf einer dreidimensional im Raum beweglichen, eigenständig positionierbaren (, auch als sogenannter Medienlift bezeichenbaren) Vorrichtung mit Bedien-, Medien-, Multimedia- und/oder Licht-Terminal, das aus einer Park- oder Ruheposition, insbesondere oberhalb von etwa 2,1 Meter, in eine Arbeitsposition oder Bedienstellung, insbesondere unterhalb von etwa 1,6 Meter, verfahren werden kann und hierbei eine nahezu kreisförmige Reichweite im Raum ermöglicht, was zum Beispiel dann von Vorteil ist, wenn die Tische in einer Lehranstalt inselförmig oder gruppenförmig oder kreisförmig angeordnet sind.

Gemäß einer vorteilhaften Ausgestaltung der vorliegenden Erfindung weist die Vorrichtung eine nach Art eines Schwenkarms ausgebildete, insbesondere teleskopierbare, zum Beispiel linear verfahrbare, Säule auf, die zwischen einer unterhalb der Decke des Raums vorgesehenen horizontalen Parkposition oder Ruhestellung und einer nicht-horizontalen Arbeitsposition oder Bedienstellung um eine horizontale Achse hin und her schwenkbar ist und deren freies Ende sich in der Arbeitsposition oder Bedienstellung in Greifhöhe befindliche Versorgungs-, Medien- und/oder Dateneinrichtungen, insbesondere Versorgungs-, Medien- und/oder Datenanschlüsse, aufweist.

Die Vorrichtung gemäß der vorliegenden Erfindung ist dazu vorgesehen, in ihrer Arbeitsposition oder Bedienstellung Energie und/oder Medien und/oder Daten an mindestens einem Arbeitsplatz, insbesondere an mindestens einem Computer-, Labor- und/oder Schularbeitsplatz, zum Beispiel in einer Lehranstalt, bereitzustellen. Hierbei können mehrere Arbeitsplätze miteinander und/oder mit einer zentralen Vorrichtung verbunden sein.

Erfindungsgemäss ist der Arm oder die Säule der Vorrichtung zum einen zwischen der, unterhalb der Decke befindlichen horizontalen Parkposition oder Ruhestellung und der nicht-horizontalen Arbeitsposition oder Bedienstellung um eine horizontale Achse schwenkbar, insbesondere aus einer nach Art eines Gehäuses ausgebildeten Aufnahmeeinheit ausschwenkbar und in diese Aufnahmeeinheit wieder einschwenkbar.

Zusätzlich zu dieser linearen Verschwenkbarkeit ist auch eine nahezu kreisförmige Reichweite der Versorgungs-, Medien- und/oder Dateneinrichtungen gegeben, indem dem dem freien Ende entgegengesetzten Ende der Säule ein Gelenk, insbesondere ein Drehgelenk, zum Beispiel ein Kugelgelenk, zugeordnet ist. Hierdurch weist die Vorrichtung eine gegenüber dem Stand der Technik signifikant erhöhte Flexibilität, insbesondere im Sinne einer kreisförmigen Reichweite, auf.

Mittels dieses Gelenks ist die Säule außerhalb der Parkposition oder Ruhestellung, insbesondere bei Überschreiten eines bestimmten Verschwenkungswinkels, zum Beispiel bei einer Verschwenkung von mehr als etwa zwanzig Grad aus der Horizontalen, um eine vertikale Achse rotierbar, insbesondere in einem Winkelbereich von zum Beispiel etwa 270 Grad zwischen einem ersten Grenzwinkel und einem zweiten Grenzwinkel.

In zweckmäßiger Weise kann im Bereich des ersten Grenzwinkels und im Bereich des zweiten Grenzwinkels jeweils ein, insbesondere gedämpfter, Anschlag vorgesehen sein, um ein Überschreiten des ersten bzw. zweiten Grenzwinkels zu verhindern.

Die vorliegende Erfindung beruht also auf einer dreidimensionalen Verfahrbarkeit der Vorrichtung, insbesondere in ebener x- und y-Richtung (sogenannte Grundrissfläche) sowie in vertikaler z-Richtung (, also in der Höhe). In bevorzugter Weise kann die Vorrichtung aus jeder beliebigen Arbeitsposition oder Bedienstellung automatisch, insbesondere auf Knopfdruck, und selbstständig in die Parkposition oder Ruhestellung zurück verfahren werden.

Auf diese Weise kann das Terminal bei einer Deckenhöhe von zum Beispiel zumindest etwa 2,4 Meter oberhalb von etwa 2,1 Meter einfahren, wobei der Arm oder die Säule mit dem Terminal im Wesentlichen flächenbündig und/oder im Wesentlichen innerhalb der Kontur der Aufnahmeeinheit versenkbar ist, zum Beispiel in einer Ausnehmung oder Aussparung der Aufnahmeeinheit, wodurch eine kompakte Bauhöhe der Vorrichtung in der Parkposition oder Ruhestellung ermöglicht wird.

Die nach Art eines Schwenk- und Dreharms ausgebildete und elektromotorisch und/oder pneumatisch antreibbare Säule kann sich in vorteilhafter Weise aus zumindest partiell teleskopartig ineinander verschieblichen, insbesondere biegbaren, Abschnitten oder Elementen zusammensetzen.

Im Unterschied zu den Lösungen aus dem Stand der Technik, mit denen lediglich ein punktförmiger bzw. flächiger Bereich abdeckbar ist (= ein- bzw. zweidimensionale Abdeckung), kann mit der Kombination von Rotations- und Schwenkmechanismus also ein räumlicher Bereich, das heißt ein Volumenbereich abgedeckt werden (= dreidimensionale Abdeckung).

Das freie Ende des Arms oder der Säule ist mit den sich in der Arbeitsposition oder Bedienstellung etwa in Greifhöhe befindlichen, insbesondere an und/oder in mindestens einem Anschluss-, Bedien- und/oder Multimediamodul, zum Beispiel Anschluss-, Bedien- und/oder Multimediakasten oder Anschluss-, Bedien- und/oder Multimediaterminal, zusammengefassten Versorgungs-, Medien- und/oder Dateneinrichtungen versehen.

Dieses Modul kann mit konventionellen Anschlüssen, wie etwa mit mindestens einem Druckluft- und/oder Gasanschluss (mit, zum Beispiel aus Sicherheitsgründen, abschaltbarer Gaszufuhr in der Parkposition oder Ruhestellung des Arms oder der Säule), mit mindestens einem Abluft-Anschluss oder mindestens einer (Punkt-)Absaugung, mit mindestens einem Wasseranschluss (bis auf Bedienhöhe im Medienkopf), mit mindestens einer Steckdose für Strom (zum Beispiel Niederspannung, 230 Volt, 400 Volt) und/oder mit mindestens einer Telekommunikationsschnittstelle für Daten (zum Beispiel Ethernet, DVI, HDMI, VGA, Audio, Video, USB) bestückt sein.

Für eine derart breite und umfangreiche Bestückung kann es von Vorteil sein, ein Kabel- und Leitungsmanagement für gasförmige und flüssige Medien, für die elektrische Spannungsversorgung (zum Beispiel 230 Volt), für die (Telekommunikations-)Daten, für die verschiedenen Gase und/oder für die Druckluft, das heißt für die Vielfalt der zur Verfügung stehenden Medien dergestalt vorzusehen, dass - zum Beispiel aus Sicherheitsgründen und/oder zum Schutz vor Vandalismus - unterhalb von beispielsweise 2,1 Metern keinerlei Kabel oder Leitungen sichtbar oder zugänglich sind.

Gemäß einer besonders zweckmäßigen Weiterbildung der vorliegenden Erfindung kann das Modul, insbesondere das Multimediaterminal, beidseitig bestückbar sein.

So können zum Beispiel auf der Vorderseite des Moduls und/oder auf der Rückseite des Moduls als integrierbares Zubehör mindestens ein Bedienelement oder Bedienpanel oder Display oder Monitor, mindestens ein Akustikelement, zum Beispiel mindestens ein Lautsprecher und/oder mindestens ein Mikrofonmodul, mindestens eine Klimatisierung, mindestens eine Leuchte, mindestens ein Miniprojektor, mindestens ein Not-Aus-Knopf oder Not-Aus-Schalter, mindestens ein Bedienfeld für eine Raumsteuerung, mindestens ein Touchdisplay oder Touchmonitor, mindestens eine Webcam und/oder weiteres ansteckbares Zubehör vorgesehen sein.

Das Anschluss-, Bedien- und/oder Multimediamodul kann insbesondere austauschbar ausgebildet sein, insbesondere mit vier bis zwölf Bestückungen zuzüglich zweier Armaturenplätze, optionalerweise mit jeweiligem Doppelauslass.

Die Austauschbarkeit insbesondere der Abdeckungen oder Blenden des Moduls ermöglicht in vorteilhafter und insbesondere kostensparender Weise eine Änderung oder Erweiterung der Versorgungs-, Medien- und/oder Dateneinrichtungen zu einem späteren Zeitpunkt.

In zweckmäßiger Weise können die Versorgungs-, Medien- und/oder Dateneinrichtungen also am und/oder im Anschluss-, Bedien- und/oder Multimediamodul zusammengefasst sein, wobei dieses, insbesondere höhenverstellbar und/oder verdrehbar ausgebildete, Modul gemäß einer bevorzugten Ausführungsform der vorliegenden Erfindung eine flache Gestalt oder flächige Erstreckung aufweisen kann.

Zum Ausrichten des Moduls, insbesondere zum Erleichtern der Bedienbarkeit des Moduls und/oder zum Verbessern der Erreichbarkeit des Moduls, kann dieses in jeder beliebigen Arbeitsposition oder Bedienstellung der Vorrichtung
- um eine zur Längserstreckung der Säule im Wesentlichen senkrechte erste Achse schwenkbar ausgebildet sein, was insbesondere ein Senkrechtstellen des Moduls in jeder beliebigen Arbeitsposition oder Bedienstellung ermöglicht, und/oder,
- insbesondere in einem Winkelbereich von etwa sechzig Grad, um eine zur ersten Achse im Wesentlichen senkrechte, zur flächigen Erstreckung des Anschlusskastens im Wesentlichen parallele zweite Achse verdrehbar ausgebildet sein.

Die Versorgungs-, Medien- und/oder Dateneinrichtungen, insbesondere die Versorgungs-, Medien- und/oder Datenanschlüsse, können zum Beispiel in einer Reihe oder in zwei übereinanderliegenden Reihen angeordnet sein.

Nach einer vorteilhaften Weiterbildung der vorliegenden Erfindung kann der Vorrichtung mindestens ein aus, insbesondere ein im Wesentlichen U-förmiges sowie nach oben offenes Profil aufweisenden, Teilstücken zusammensetzbarer Kanal zur Aufnahme der Kabel und Leitungen, insbesondere der Versorgungs-, Medien- und/oder Datenkabel und -leitungen, zugeordnet sein.

Dieser, insbesondere aus Teilstücken zusammensetzbare, Kanal kann in zweckmäßiger Weise mittels mindestens eines Deckels abdeckbar sein. Unabhängig hiervon oder in Verbindung hiermit kann das Profil des Kanals mit mindestens einer Anschlussstelle für die Aufnahmeeinheit und/oder für die Säule versehen sein.

Gemäß einer bevorzugten Ausführungsform der vorliegenden Erfindung können innerhalb der Säule zu den Versorgungs-, Medien- und/oder Dateneinrichtungen, insbesondere zu den Versorgungs-, Medien- und/oder Datenanschlüssen, führende Kabel und Leitungen installiert sein, die im Bereich der der Säule zugeordneten Schwenk-/Drehlagerung mit Anschlusselementen für die von der Decke, insbesondere aus dem Kanal, kommenden Kabel und Leitungen versehen sein können.

Die vorliegende Erfindung betrifft schließlich den Einsatz mindestens einer Vorrichtung der vorstehend dargelegten Art zum Visualisieren von Handlungen an mindestens einem Arbeitsplatz, insbesondere an mindestens einem Computer-, Labor- und/oder Schularbeitsplatz, zum Beispiel in einer Lehranstalt.

Verwendet wird die vorliegende Erfindung also vorzugsweise in einem Raum, insbesondere einer Lehranstalt, zum Beispiel einer Schule. In diesem Raum sind üblicherweise Tische, insbesondere Arbeitstische, zum Beispiel von Computer-Arbeitsplätze, aufgestellt, denen jeweils Stühle zugeordnet sein können. Aufgrund ihrer dreidimensionalen Bewegbarkeit kann die vorliegende Erfindung hierbei mit besonderem Vorteil eingesetzt werden, wenn die Tische inselförmig oder gruppenförmig oder kreisförmig angeordnet sind.

Die Installation der Versorgungs-, Medien- und/oder Datenleitungen zu diesen Arbeitsplätzen kann über ein gerüstartig aufbaubares System erfolgen, das mindestens einen in Längsrichtung des Raums verlaufenden Kanal aufweist, der mit Hängehaltern an der Decke aufgehängt ist. Das Ende des Kanals kann mit mindestens einem Halter an der Rückwand des Raumes befestigt sein.

Im Kanal sind die für die Arbeitsplätze benötigten Versorgungs-, Medien- und/oder Datenleitungen verlegt. An jedem Arbeitsplatz zweigt vom Kanal eine Säule, insbesondere mit Trapezprofil, ab, die das Anschluss-, Bedien- und/oder Multimediamodul trägt, das mit den Versorgungs-, Medien- und/oder Dateneinrichtungen versehen ist. In deren Anschluss-, Bedien- und/oder Multimediaanschlüsse können die zugehörigen Anschlusselemente, zum Beispiel Stecker und dergleichen, eingestreckt werden, die zu den einzelnen Arbeitsplätzen führen.

Hierbei handelt es sich um elektrische Stromversorgungsleitungen und um Bus-Systeme, aber auch um Datenleitungen, die die einzelnen Arbeitsplätze miteinander und gegebenenfalls mit einer zentralen Stelle, zum Beispiel einem Lehrenden-Computer, verbinden.

Der Kanal ist etwa in einer Raumhöhe von 2,5 Meter angeordnet, das heißt deutlich oberhalb der Greifhöhe auch von großen Personen. Die Säulen mit den Anschluss-, Bedien- und/oder Multimediamodulen ragen in der Arbeitsposition oder Bedienstellung nach unten ab, so dass sich Anschluss-, Bedien- und/oder Multimediamodule in einer Höhe von etwa 1,6 Meter bis etwa 1,8 Meter über dem Boden befinden; mithin sind die Anschluss-, Bedien- und/oder Multimediaanschlüsse auch für kleinere Personen ohne Weiteres zugänglich, ohne dass hierfür Hilfsmittel benötigt werden.

Im Kanal können außer, zum Beispiel elektrischen, Versorgungs-, Datenübertragungs- und/oder Medienleitungen auch weitere Kabel und Leitungen verlegt sein, insbesondere eine oder mehrere Gasleitungen sowie eine oder mehrere Wasserleitungen, die dann ebenfalls zu als Ventile ausgebildeten Versorgungsanschlüssen im Anschluss-, Bedien- und/oder Multimediamodul führen.

Der Kanal kann aneinandergesetzte U-förmige Profile aufweisen, die nach oben offen sind. Diese Profile sind nach oben mit lösbaren, insbesondere verrastbaren, Deckeln verschlossen, die in einzelne Abschnitte unterteilt sind. Die Leitungen sind von oben in die den Kanal bildenden Profile eingelegt und zweckmäßigerweise im Bereich der Säulen mit Steckanschlüssen für die Abzweigungsleitungen zu den Anschlüssen des Anschluss-, Bedien- und/oder Multimediamoduls versehen. Es ist somit möglich, die von unten am Kanal angebrachten Säulen an vorbereiteten Stellen anzubringen und auch zu entfernen.

Bei einer abgewandelten Ausführungsform kann vorgesehen sein, dass sich die Säulen aus teleskopartig relativ zueinander bewegbaren Teilen zusammensetzen, so dass des Anschluss-, Bedien- und/oder Multimediamodul in der Höhe (= in vertikaler z-Richtung) einstellbar ist.

Um eine räumlich möglichst vollständig abdeckende, insbesondere flächendeckende, Versorgung durch (zumindest nahezu) kreisförmige Reichweite zu erzielen, kann am dem Kanal zugewandten Ende der Säule das, insbesondere eine Rotation um eine vertikale Achse ermöglichende, Gelenk angeordnet sein.

Hierdurch ist mit der vorliegenden Erfindung ein besonders hohes Maß an Flexibilität erzielbar, weil die Vorrichtung dreidimensional im Raum navigierbar, das heißt nicht ausschließlich höhenverstellbar und nicht ausschließlich starr an einem Punkt bedienbar ist.

In bevorzugter Weise kann für den Schwenkmechanismus mindestens eine Feststellbremse vorgesehen sein. Unabhängig hiervon oder in Verbindung hiermit kann mindestens ein verstellbarer Schwenkanschlag vorgesehen sein.

Darüber hinaus kann vorgesehen sein, dass das Anschluss-, Bedien- und/oder Multimediamodul selbst um eine vertikale Achse verdrehbar ist, so dass es jeweils in die günstigste Position ausrichtbar ist.

Bei allen Ausführungsformen des, insbesondere von der Decke aus operierenden, Medien(versorgungs)systems gemäß der vorliegenden Erfindung müssen weder Böden noch Wände noch Decken eines Raums aufgebrochen oder durchbrochen werden, um das, insbesondere gerüstartige, System zu montieren.

Das System ist somit montierbar und auch demontierbar, ohne dass der betreffende Raum wesentlich verändert wird. Dadurch ist es möglich, den Raum vielfältig zu nutzen.

### Kurze Beschreibung der Zeichnungen

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 nachgeordneten Ansprüche verwiesen, andererseits werden weitere Ausgestaltungen, Merkmale und Vorteile der vorliegenden Erfindung nachstehend unter Anderem anhand eines durch die Zeichnungen veranschaulichten Ausführungsbeispiels gemäß der vorliegenden Erfindung näher erläutert; etwaige Bemessungsangaben sind rein exemplarisch zu verstehen.

Es zeigt:
- Fig. 1A: eine perspektivische Aufsicht auf ein Ausführungsbeispiel einer Vorrichtung gemäß der vorliegenden Erfindung;
- Fig. 1B: eine perspektivische Unteransicht der sich in Parkposition oder Ruhestellung befindlichen Vorrichtung aus Fig. 1A;
- Fig. 2A: eine perspektivische Unteransicht der Vorrichtung aus Fig. 1B nach Verlassen der Parkposition oder Ruhestellung;
- Fig. 2B: eine perspektivische Unteransicht der sich in Arbeitsposition oder Bedienstellung befindlichen Vorrichtung aus Fig. 2A, wobei der Anschlusskasten sowohl um eine zur Längserstreckung der Säule im Wesentlichen senkrechte erste Achse geschwenkt als auch um eine zur ersten Achse im Wesentlichen senkrechte, zur flächigen Erstreckung des als Medienterminal bezeichenbaren Anschluss-, Bedien- und/oder Multimediamoduls im Wesentlichen parallele zweite Achse verdreht ist;
- Fig. 3A: eine schematische Visualisierung der dreidimensionalen Verfahrbarkeit der Vorrichtung aus Fig. 1A bis Fig. 2B in Aufsicht;
- Fig. 3B: eine schematische Visualisierung der dreidimensionalen Verfahrbarkeit der Vorrichtung aus Fig. 1A bis Fig. 2B in Seitenansicht; und
- Fig. 3C: eine perspektivische Visualisierung der dreidimensionalen Verfahrbarkeit der Vorrichtung aus Fig. 1A bis Fig. 2B.

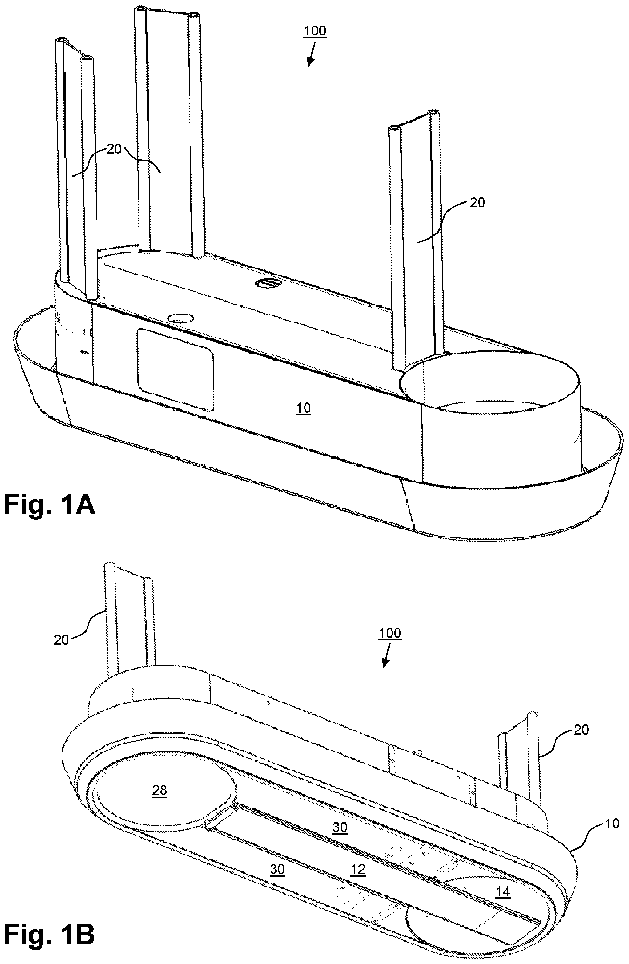

Gleiche oder ähnliche Ausgestaltungen, Elemente oder Merkmale sind in Fig. 1A bis Fig. 3C mit identischen Bezugszeichen versehen.

### Bester Weg zur Ausführung der vorliegenden Erfindung

In Fig. 1A bis Fig. 3C ist die prinzipielle Funktionsweise eines nach Art eines Medienlifts ausgestalteten Deckensystems gemäß der vorliegenden Erfindung zum Bereitstellen von Versorgungs-, Medien- und/oder Dateneinrichtungen 24 an mindestens einem Arbeitsplatz, insbesondere an mindestens einem Computer-, Labor- und/oder Schularbeitsplatz, verdeutlicht.

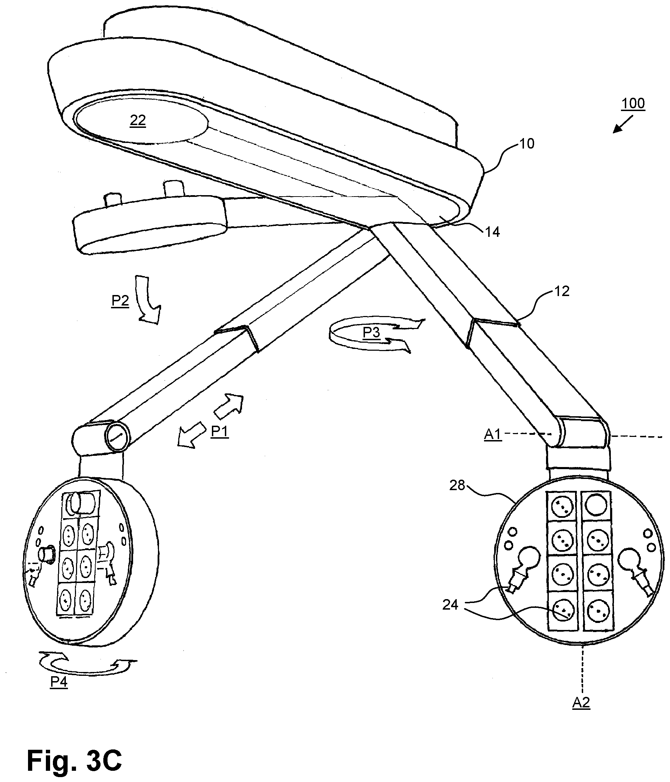

Die unterhalb der Decke eines Raums für sich im Raum befindliche Verbraucher anordbare multifunktionale Vorrichtung 100 weist eine nach Art eines Schwenk- und Dreharms ausgebildete und teleskopierbare Säule 12 auf. In diesem Zusammenhang bedeutet teleskopierbar, dass die Säule 12 um etwa 45 Zentimeter linear verfahrbar ist, wie durch Pfeil P1 in Fig. 3C angedeutet ist.

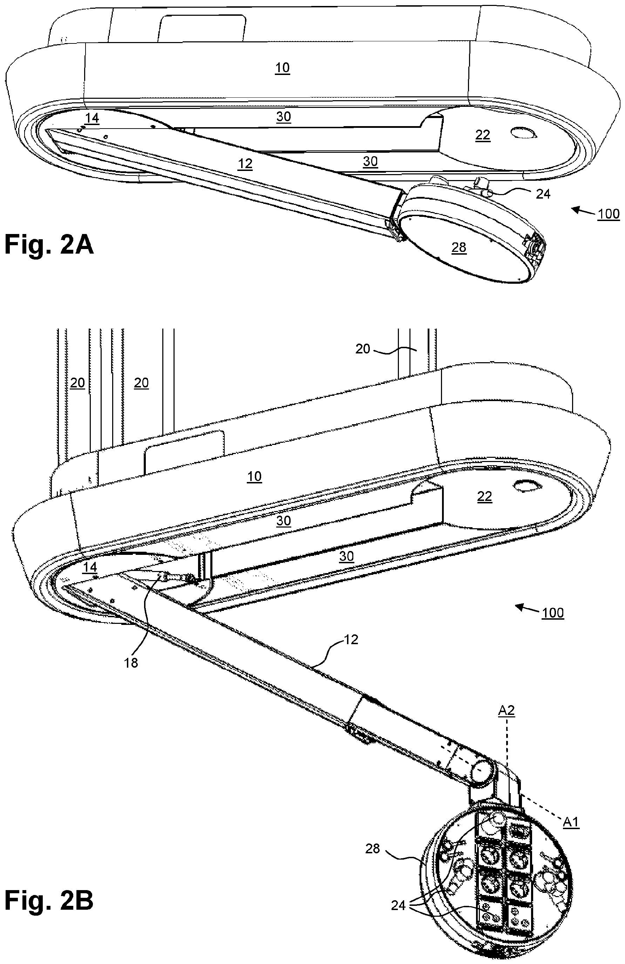

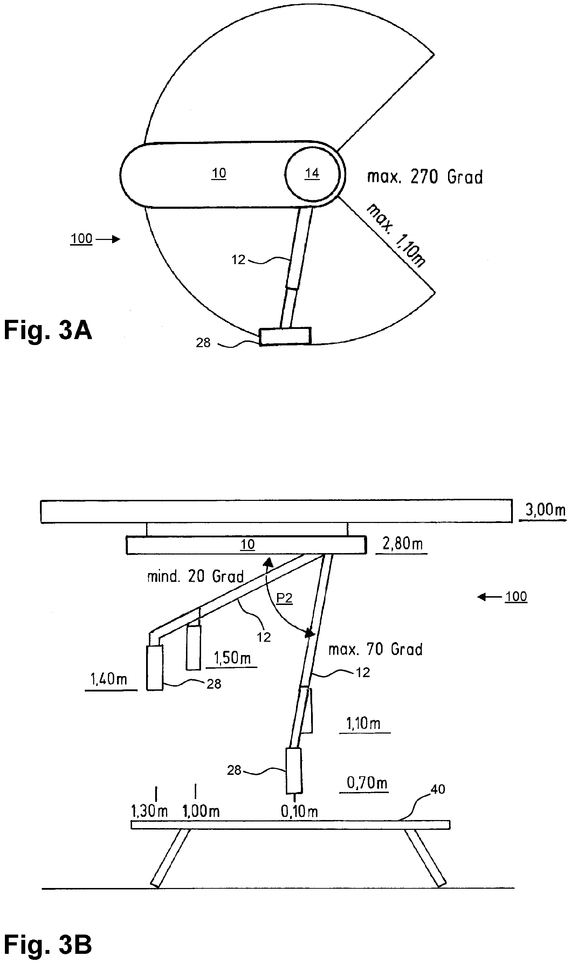

Wie durch Pfeil P2 in Fig. 3B und in Fig. 3C angedeutet ist, kann diese Säule 12 zwischen einer im Wesentlichen horizontalen Parkposition oder Ruhestellung (vgl. Fig. 1A und Fig. 1B) und einer nicht-horizontalen Arbeitsposition oder Bedienstellung (vgl. Fig. 2A bis Fig. 3C) um eine im Wesentlichen horizontale Achse hin und her geschwenkt werden (vgl. Fig. 3B), wobei das freie Ende der Säule 12 die sich in der Arbeitsposition oder Bedienstellung in Greifhöhe befindlichen Versorgungs-, Medien- und/oder Dateneinrichtungen 24 aufweist.

Das dem freien Ende der Säule 12 entgegengesetzte Ende der Säule 12 ist einem Drehgelenk 14 zugeordnet, mittels dessen die Säule 12 außerhalb der Parkposition oder Ruhestellung, insbesondere bei Überschreiten eines bestimmten Verschwenkungswinkels, zum Beispiel bei einer Verschwenkung von mehr als etwa zwanzig Grad aus der Horizontalen (vgl. Fig. 2B bis Fig. 3C), in einem Winkelbereich von etwa 270 Grad (vgl. Fig. 3A) um eine im Wesentlichen vertikale Achse rotierbar ist, wie durch Pfeil P3 in Fig. 3C angedeutet ist.

Im Bereich eines ersten Grenzwinkels, definierbar bei +135 Grad, und im Bereich eines zweiten Grenzwinkels, definierbar bei -135 Grad, ist jeweils ein, insbesondere gedämpfter, Anschlag vorgesehen, der ein Überschreiten des ersten bzw. zweiten Grenzwinkels verhindert.

Die Versorgungs-, Medien- und/oder Dateneinrichtungen 24 sind in einem kastenförmigen Anschluss-, Bedien- und/oder Multimediamodul 28 (vgl. Fig. 1B bis Fig. 3C) zusammengefasst, das um eine zur Längserstreckung der Säule 12 im Wesentlichen senkrechte erste Achse A1 (vgl. Fig. 2B und Fig. 3C) schwenkbar ausgebildet ist, was ein Senkrechtstellen des Moduls 28 in jeder beliebigen Arbeitsposition oder Bedienstellung ermöglicht.

Wie durch Pfeil P4 in Fig. 3C angedeutet ist, ist das Modul 28 des Weiteren, insbesondere in einem Winkelbereich von etwa sechzig Grad, um eine zur ersten Achse A1 im Wesentlichen senkrechte, zur flächigen Erstreckung des Anschluss-, Bedien- und/oder Multimediamoduls 28 im Wesentlichen parallele zweite Achse A2 (vgl. Fig. 2B und Fig. 3C) verdrehbar ausgebildet.

Um eine derartige Beweglichkeit des Moduls 28 in alle Richtungen zu ermöglichen, kann innerhalb des Moduls 28 mindestens eine einhängbare Kabelschutzspirale vorgesehen sein.

Das Modul 28 kann als Bedienpanel mit integrierter Tischbeleuchtung und/oder mit integriertem Touch-Display oder Touch-Monitor ausgestaltet sein.

Wie zum Beispiel der Darstellung in Fig. 1A entnehmbar, ist die Säule 12 einschließlich des Moduls 28 in ihrer Parkposition oder Ruhestellung in einer zentralen Aufnahme 22 einer der Decke des Raums zugeordneten, nach Art einer Konsole ausgebildeten Aufnahmeeinheit 10 aufgenommen. Hierbei kann die Säule 12 einschließlich des Moduls 28 aus jeder beliebigen dreidimensionalen Arbeitsposition oder Bedienstellung automatisch, insbesondere auf Knopfdruck, und selbstständig in die Aufnahmeeinheit 10 zurück verfahren werden.

Diese Aufnahmeeinheit 10 ist mittels dreier Halter 20 an der Decke des Raums angebracht und nach Art eines Gehäuses ausgebildet. Das Drehgelenk 14 ist in dieser Aufnahmeeinheit 10 untergebracht.

Zum Beleuchten von Arbeitsplätzen oder Labortischen 40 (vgl. Fig. 3B) unterhalb der Aufnahmeeinheit 10 ist in der Aufnahmeeinheit 10 eine umlaufende Beleuchtung 30 integriert, insbesondere etwa 500 Lux am äußersten Rand des darunter stehenden Arbeitstisches 40, zum Beispiel in direkter und/oder indirekter LED-Technik. Hierbei weist die Aufnahmeeinheit 10 optionalerweise Durchbrüche und/oder transluzentes Plexiglas für die LED-Leuchtkörper in der Aufnahmeeinheit 10 auf.

Um die innerhalb der Säule 12 zu den Versorgungs-, Medien- und/oder Dateneinrichtungen 24 führenden Kabel und Leitungen innerhalb der Aufnahmeeinheit 10 entsprechend anordnen zu können, weist die Aufnahmeeinheit 10 im Bereich des Drehgelenks 14 ein als beweglichen Schlitten ausgebildetes bewegliches Umlenkelement in Form einer oder mehrerer Rollen auf.

Diesem Schlitten ist ein Ausgleichselement 18 in Form einer Gasdruckfeder zugeordnet, wobei durch dieses Ausgleichselement 18 der durch das lineare Verfahren der Säule 12 bedingte Versatz der Kabel und Leitungen innerhalb der Aufnahmeeinheit 10 kompensierbar ist.

Mittels der anhand Fig. 1A bis Fig. 3C veranschaulichten Vorrichtung 100 ist eine flächendeckende Medienversorgung durch kreisförmige Reichweite von etwa 2,2 Meter erzielbar, wobei die Vorrichtung 100 eine besonders hohe Flexibilität aufweist, weil sie dreidimensional im Raum navigierbar ist, das heißt nicht nur höhenverstellbar und nicht nur starr an einem Punkt.

In Fig. 3B ist angedeutet, dass die erfindungsgemäße Vorrichtung 100 auch ausgenutzt werden kann, um Labor-Arbeitsplätze mit Versorgungsleitungen und mit Datenleitungen zu versehen. Hierzu können auf einem Labortisch 40 zum Beispiel ein Messgerät und/oder ein Analysegerät mit einer Computerauswerteeinrichtung abgestellt sein. Die elektrischen Versorgungsleitungen sowie Versorgungsleitungen mit Gas, mit Wasser und/oder mit Druckluft sind in einem Kanal verlegt und am Arbeitsplatz mittels der Säule 12 zum Arbeitsplatz abgezweigt.

Der modulartige Anschlusskasten 28 am freien unteren Ende der Säule 12 enthält die Elektroanschlüsse, Anschlüsse für Datenleitungen und Anschlüsse für Versorgungsleitungen für Gas, Wasser und/oder Druckluft, an die mittels Kabel und/oder Leitungen das Messgerät und/oder das Analysegerät angeschlossen sind. Der Anschlusskasten 28 kann mit mindestens einer Kabelführung versehen sein, so dass die Kabel Kabel und/oder Leitungen verlegt werden können, ohne an der Oberfläche des Tisches 40 zu stören.

Die Vorrichtung 100 ist nicht notwendigerweise auf ein an der Decke des Raums angebrachtes Kanalsystem angewiesen, sondern kann in Form einzelner Konsolen-Einheiten 10 an der Decke aufgehängt werden und eignet sich dadurch vorzüglich für verschiedene Raumkonzepte. Die Medienversorgung, insbesondere alle Kabel und Leitungen, bis in eine Höhe von etwa 2,2 Meter Höhe können aus Sicherheitsgründen geschützt bzw. nicht zugänglich ausgebildet sein.

So ist die Vorrichtung 100 ohne Weiteres an verschiedenen Deckentypen, zum Beispiel an einer abgehängten Decke, an einer Hohlraumdecke, an einer Rippendecke oder an einer Sichtbetondecke, einfach montierbar und ausrichtbar; im Falle einer abgehängten Decke kann oberhalb derselben ein einfacher Leitungskanal vorgesehen sein sowie eine Blende für die abgehängte Decke.

Ein derartiges einfaches und kostengünstiges Montagekonzept ermöglicht im Bedarfsfalle einen nachträglichen Leitungsaustausch sowie eine nachträgliche Leitungsergänzung, insbesondere in Form einer Durchschlaufbarkeit von Vorrichtung 100 zu Vorrichtung 100.

Generell gewährleistet der modulare Aufbau in Form der konsolenartigen Aufnahmeeinheiten 10, dass die Vorrichtung 100 auch nachträglich, das heißt zum Beispiel bei sich wandelndem Medienbedarf oder sich ändernden Sicherheitsbestimmungen, problemlos ergänzbar und/oder nachrüstbar und/oder skalierbar ist, etwa im Falle einer räumlichen Erweiterung.

Durch die Kombination aus Schwenk- und Rotationsmechanismus für die elektromotorisch ein- und ausfahrbare Säule 12 ist eine einfache und flexible Anpassung der Vorrichtung 100 an unterschiedliche Raumhöhen ebenso wie eine ergonomische Höhenanpassung problemlos möglich; insbesondere kann die Vorrichtung 100 für Raumhöhen zwischen etwa 2,4 Meter und etwa vier Meter eingesetzt werden.

Im Bedarfsfalle, zum Beispiel im Notfall und/oder bei Stromausfall, ist die Vorrichtung 100, insbesondere deren Säule 12, auch manuell verfahrbar und rotierbar. Generell zeichnet sich die Vorrichtung 100 durch eine sehr robuste Bauweise aus, so etwa durch eine Belastbarkeit mit bis zu etwa 150 Kilogramm, was infolge eines möglicherweise nicht stets sachgerechten Umgangs mit der Vorrichtung 100 in einer Lehranstalt vorteilhaft erscheint.

Als weitere Sicherung vor Überbelastung oder gar vor Vandalismus kann für den Schwenkmechanismus mindestens eine Feststellbremse und/oder mindestens ein verstellbarer Schwenkanschlag vorgesehen sein.

Lehrkräfte werden an der Vorrichtung 100 die sehr kurze Rüstzeit, das heißt die sehr schnelle Verfügbarkeit der Vorrichtung 100 innerhalb von maximal etwa zehn Sekunden zu schätzen wissen, so dass im Unterrichtsraum keine Unruhe aufkommen kann. Die ergonomische Verfügbarkeit der Medien in einer maximalen Bedienhöhe von etwa 1,8 Metern im Anschlusskasten oder Medienterminal 28 ermöglicht auch körperlich noch nicht ausgewachsenen Personen ein problemloses Arbeiten und Forschen mit der Vorrichtung 100.

### Bezugszeichenliste

- 100: Vorrichtung
- 10: Aufnahmeeinheit
- 12: Säule
- 14: Gelenk, insbesondere Drehgelenk, zum Beispiel Kugelgelenk
- 18: Ausgleichselement, insbesondere Gasdruckfeder
- 20: Halter oder Halterung, insbesondere Deckenhalter oder Deckenhalterung
- 22: Ausnehmung oder Aussparung der Aufnahmeeinheit 10
- 24: Versorgungs-, Medien- und/oder Dateneinrichtungen
- 28: Anschluss-, Bedien- und/oder Multimediamodul, insbesondere Anschluss-, Bedien- und/oder Multimediakasten oder Anschluss-, Bedien- und/oder Multimediaterminal
- 30: Beleuchtungselement
- 40: Tisch, insbesondere Arbeitstisch oder Labortisch, zum Beispiel an Arbeitsplatz, wie etwa an Computer-Arbeitsplatz
- A1: erste Achse
- A2: zweite Achse
- P1: erster Pfeil
- P2: zweiter Pfeil
- P3: dritter Pfeil
- P4: vierter Pfeil

## Patentansprüche

1. Multifunktionale Vorrichtung (100), aufweisend eine zwischen einer unterhalb der Decke eines Raums vorgesehenen horizontalen Parkposition und einer nicht-horizontalen Arbeitsposition bewegbare Säule (12), wobei das Versorgungs-, Medien- oder Dateneinrichtungen (24) aufweisende freie Ende der Säule (12) dreidimensional verfahrbar ist, **dadurch gekennzeichnet, dass** die Säule (12) nach Art eines um eine horizontale Achse hin und her schwenkbaren Schwenkarms ausgebildet ist, der außerhalb der Parkposition nur bei Überschreiten eines bestimmten Winkels der Verschwenkung aus der Horizontalen um eine vertikale Achse rotierbar ist, und dass das dem freien Ende entgegen gesetzte Ende der Säule (12) einem Gelenk (14) zugeordnet ist.

2. Vorrichtung gemäß Anspruch 1, **dadurch gekennzeichnet, dass** die Säule (12) nur bei einer Verschwenkung von mehr als etwa zwanzig Grad aus der Horizontalen um eine vertikale Achse rotierbar ist.

3. Vorrichtung gemäß Anspruch 2, **dadurch gekennzeichnet, dass** die Säule (12) in einem Winkelbereich von 270 Grad zwischen einem ersten Grenzwinkel und einem zweiten Grenzwinkel rotierbar ist.

4. Vorrichtung gemäß Anspruch 3, **dadurch gekennzeichnet, dass** im Bereich des ersten Grenzwinkels und im Bereich des zweiten Grenzwinkels jeweils ein Anschlag vorgesehen ist, der ein Überschreiten des ersten bzw. zweiten Grenzwinkels verhindert.

5. Vorrichtung gemäß mindestens einem der Ansprüche 1 bis 4, **dadurch gekennzeichnet, dass** die Säule (12) teleskopierbar ist.

6. Vorrichtung gemäß mindestens einem der Ansprüche 1 bis 5, **dadurch gekennzeichnet, dass** sich in der Arbeitsposition die Versorgungs-, Medien- oder Dateneinrichtungen (24) in Greifhöhe befinden.

7. Vorrichtung gemäß mindestens einem der Ansprüche 1 bis 6, **dadurch gekennzeichnet, dass** die Versorgungs-, Medien- oder Dateneinrichtungen (24) an oder in mindestens einem Anschluss-, Bedien- oder Multimediamodul (28) zusammengefasst sind.

8. Vorrichtung gemäß Anspruch 7, **dadurch gekennzeichnet, dass** das Anschluss-, Bedien- oder Multimediamodul (28)
- um eine zur Längserstreckung der Säule (12) senkrechte erste Achse (A1) schwenkbar ausgebildet ist und/oder,
- um eine zur ersten Achse senkrechte zweite Achse (A2) verdrehbar ausgebildet ist.

9. Vorrichtung gemäß mindestens einem der Ansprüche 1 bis 8, **dadurch gekennzeichnet, dass** die Säule (12) aus jeder Arbeitsposition zurück in die Parkposition verfahrbar ist.

10. Vorrichtung gemäß mindestens einem der Ansprüche 1 bis 9, **dadurch gekennzeichnet, dass** die Säule (12) in ihrer Parkposition zumindest partiell in einer Aufnahmeeinheit (10) aufnehmbar ist.

11. Vorrichtung gemäß Anspruch 10, **dadurch gekennzeichnet,**
- **dass** die Aufnahmeeinheit (10) nach Art eines Gehäuses ausgebildet ist und/oder
- **dass** die Aufnahmeeinheit (10) das Gelenk (14) enthält und/oder
- **dass** die Aufnahmeeinheit (10) mindestens ein Beleuchtungselement (30) aufweist.

12. Vorrichtung gemäß mindestens einem der Ansprüche 1 bis 11, **gekennzeichnet durch** im Bereich des Gelenks (14) über mindestens einen beweglichen Schlitten geführte, innerhalb der Säule (12) zu den Versorgungs-, Medien- oder Dateneinrichtungen (24) führende Leitungen für elektrischen Strom oder für Datensignale oder für mindestens ein flüssiges Medium, zum Beispiel für Wasser, oder für mindestens ein gasförmiges Medium, zum Beispiel Druckluft.

13. Vorrichtung gemäß Anspruch 12, **dadurch gekennzeichnet, dass** die Leitungen in der Säule (12) untergebracht sind.

14. Vorrichtung gemäß Anspruch 12 oder 13, **gekennzeichnet durch** mindestens ein dem Schlitten zugeordnetes Ausgleichselement (18) zum Ausgleichen des **durch** das lineare Verfahren der Säule (12) bedingten Versatzes der Leitungen.

## Claims

1. A multifunctional device (100), having a pillar (12), which can be moved between a horizontal park position provided below the ceiling of a room and a non-horizontal work position, it being possible to move the free end of the pillar (12) having supply, media or data devices (24) in a three-dimensional manner, **characterized in that** the pillar (12) is constructed in the manner of a pivot arm, which can be pivoted back and forth about a horizontal axis, which pivot arm can be rotated about a vertical axis, outside of the park position, only if a certain angle of pivoting out of horizontal is exceeded, and **in that** the end of the pillar (12) opposite the free end is assigned to a joint (14) .

2. The device according to Claim 1, **characterized in that** the pillar (12) can only be rotated about a vertical axis in the event of pivoting of more than approximately twenty degrees from the horizontal.

3. The device according to Claim 2, **characterized in that** the pillar (12) can be rotated between a first limiting angle and a second limiting angle in an angular range of 270 degrees.

4. The device according to Claim 3, **characterized in that** a stop is provided in each case in the region of the first limiting angle and in the region of the second limiting angle, which stop prevents the first or second limiting angle from being exceeded.

5. The device according to at least one of Claims 1 to 4, **characterized in that** the pillar (12) can be telescoped.

6. The device according to at least one of Claims 1 to 5, **characterized in that**, in the work position, the supply, media or data devices (24) are located at access height.

7. The device according to at least one of Claims 1 to 6, **characterized in that**, in the supply, media or data devices (24) are combined at or in at least one connection, operating or multimedia module (28).

8. The device according to Claim 7, **characterized in that** the connection, operating or multimedia module (28)
- is constructed to be pivotable about a first axis (A1) perpendicular to the longitudinal extent of the pillar (12), and/or
- is constructed to be rotatable about a second axis (A2) perpendicular to the first axis.

9. The device according to at least one of Claims 1 to 8, **characterized in that** the pillar (12) can be moved out of any work position back into the park position.

10. The device according to at least one of Claims 1 to 9, **characterized in that** the pillar (12) can be accommodated, in its park position, at least partially in an accommodating unit (10).

11. The device according to Claim 10, **characterized**
- **in that** the accommodating unit (10) is constructed in the manner of a housing, and/or
- **in that** the accommodating unit (10) contains the joint (14), and/or
- **in that** the accommodating unit (10) has at least one illumination unit (30).

12. The device according to at least one of Claims 1 to 11, **characterized by** lines for electric current or for data signals or for at least one fluid medium, for example for water, or for at least one gaseous medium, for example compressed air, which lines are guided in the region of the joint (14) by means of at least one movable carriage and lead, inside the pillar (12), to the supply, media or data devices (24).

13. The device according to Claim 12, **characterized in that** the lines are accommodated in the pillar (12).

14. The device according to Claim 12 or 13, **characterized by** at least one compensating element (18) assigned to the carriage for compensating the misalignment of the lines caused by the linear movement of the pillar (12).

## Revendications

1. Dispositif multifonction (100) comportant une colonne (12) pouvant être mobile entre une position de repos horizontale prévue en dessous du plafond d'un local et une position de travail non horizontale, sachant que l'extrémité libre de la colonne (12) comportant des dispositifs d'alimentation, de média ou de données (24) peut être déplacée de façon tridimensionnelle, **caractérisé en ce que** la colonne (12) est constituée à la façon d'un bras pivotant pouvant pivoter dans les deux sens autour d'un axe horizontal, qui peut être tourné autour d'un axe vertical en dehors de la position de repos uniquement en dépassant un angle déterminé du pivotement à partir de l'horizontale et **en ce que** l'extrémité de la colonne (12) opposée à l'extrémité libre est attribuée à une articulation (14).

2. Dispositif selon la revendication 1, **caractérisé en ce que** la colonne (12) ne peut être tournée autour d'un axe vertical depuis la position horizontale que lors d'un pivotement de plus d'environ vingt degrés.

3. Dispositif selon la revendication 2, **caractérisé en ce que** la colonne (12) peut être tournée dans une plage angulaire de 270 degrés entre un premier angle limite et un deuxième angle limite.

4. Dispositif selon la revendication 3, **caractérisé en ce que** dans la plage du premier angle limite et dans la plage du deuxième angle limite une butée est respectivement prévue, qui évite un dépassement du premier ou du deuxième angle limite.

5. Dispositif selon au moins l'une quelconque des revendications 1 à 4, **caractérisé en ce que** la colonne (12) peut être télescopique.

6. Dispositif selon au moins l'une quelconque des revendications 1 à 5, **caractérisé en ce que** les dispositifs d'alimentation, de média ou de données (24) se trouvent à la hauteur de préhension.

7. Dispositif selon au moins l'une quelconque des revendications 1 à 6, **caractérisé en ce que** les dispositifs d'alimentation, de média ou de données (24) sont réunis sur ou dans au moins un module de connexion, de commande ou multimédia (28).

8. Dispositif selon la revendication 7, **caractérisé en ce que** le module de connexion, de commande ou multimédia (28)
- est constitué pouvant pivoter autour d'un premier axe (A1) perpendiculaire à l'extension longitudinale de la colonne (12), et/ou
- est constitué pouvant tourner autour d'un deuxième axe (A2) perpendiculaire au premier axe.

9. Dispositif selon au moins l'une quelconque des revendications 1 à 8, **caractérisé en ce que** la colonne (12) peut être replacée depuis chaque position de travail dans la position de repos.

10. Dispositif selon au moins l'une quelconque des revendications 1 à 9, **caractérisé en ce que** la colonne (12) peut être logée dans sa position de repos au moins en partie dans une unité de logement (10).

11. Dispositif selon la revendication 10, **caractérisé**
- **en ce que** l'unité de logement (10) est constituée à la façon d'un boîtier et/ou
- **en ce que** l'unité de logement (10) contient l'articulation (14) et/ou
- **en ce que** l'unité de logement (10) comporte au moins un élément d'éclairage (30).

12. Dispositif selon au moins l'une quelconque des revendications 1 à 11, **caractérisé par** des conduits guidés dans la zone de l'articulation (14) par au moins un berceau mobile à l'intérieur de la colonne (12) conduisant aux dispositifs d'alimentation, de média ou de données (24) pour le courant électrique ou pour des signaux de données ou pour au moins un milieu liquide, par exemple pour de l'eau ou pour au moins un milieu gazeux, par exemple de l'air comprimé.

13. Dispositif selon la revendication 12, **caractérisé en ce que** les conduits sont placés dans la colonne 12).

14. Dispositif selon la revendication 12 ou 13, **caractérisé par** au moins un élément de compensation (18) attribué au berceau pour équilibrer le déport des conduits conditionné par le déplacement linéaire de la colonne (12) .
